# EUROPEAN PATENT APPLICATION

(11) **EP 4 845 371 A1**
(43) Date of publication of application: **25.11.2026**
(21) Application number: 26175076.4
(22) Date of filing: 28.04.2026
(51) Int. Cl.: H10K 85/50, H10K 30/35, H10K 30/40, H10K 30/57

(54) **PHOTOELECTRIC CONVERSION DEVICE, METHOD FOR MANUFACTURING PHOTOELECTRIC CONVERSION DEVICE, TANDEM SOLAR CELL, AND WINDOW GLASS**

(30) Priority: 19.05.2025 JP 2025083288
(71) Applicant: Toyota Jidosha Kabushiki Kaisha, Toyota-shi, Aichi-ken 471-8571 (JP)
(72) Inventor: MATSUNOBU, Kohei, Toyota-shi 471-8571 (JP); MABUCHI, Takashi, Toyota-shi 471-8571 (JP); OKUMURA, Kenichi, Toyota-shi 471-8571 (JP)
(74) Representative: Kuhnen & Wacker Patent- und Rechtsanwaltsbüro PartG mbB

(57) **Abstract**

A photoelectric conversion device (1) according to the present disclosure includes: a first electrode layer (12), which is a transparent electrode; a second electrode layer (17); a photoactive zone (141) that is positioned between the first electrode layer (12) and the second electrode layer (17) and contains a perovskite compound as a main component; a nanoparticle zone (142) that is positioned between the photoactive zone (141) and the first electrode layer (12) and includes nanoparticles; and a passivation layer (15) that is positioned between the photoactive zone (141) and the second electrode layer (17).

## Description

### BACKGROUND

The present disclosure relates to a photoelectric conversion device, a method for manufacturing a photoelectric conversion device, a tandem solar cell, and a window glass.

Patent Literature 1 discloses a perovskite solar cell including a transparent conductive support, an electron blocking layer, a perovskite layer, an electron transport layer, a hole blocking layer, and a back electrode, in which the electron blocking layer and the hole blocking layer both include inorganic materials.

Patent Literature 1: Domestic Re-publication of PCT International Publication for Patent Application, No. 2017-547766

### SUMMARY

Incidentally, in the solar cell according to related art, there is a room for improving the photoelectric conversion efficiency. That is, there is a problem, in the solar cell and the photoelectric conversion device used in the solar cell according to related art, that photoelectric conversion efficiency is not sufficiently improved.

The present disclosure has been made in order to solve the aforementioned problem, and an object of the present disclosure is to provide a photoelectric conversion device, a method for manufacturing a photoelectric conversion device, a tandem solar cell, and a window glass capable of improving photoelectric conversion efficiency.

A photoelectric conversion device according to the present disclosure includes: a first electrode layer, which is a transparent electrode; a second electrode layer; a photoactive zone that is positioned between the first electrode layer and the second electrode layer and contains a perovskite compound as a main component; a nanoparticle zone that is positioned between the photoactive zone and the first electrode layer and includes nanoparticles; and a passivation layer that is positioned between the photoactive zone and the second electrode layer.

As a result of thorough study, the inventors of the present application have found that, since the photoelectric conversion device includes a nanoparticle zone between a photoactive zone and a first electrode layer, arithmetic average roughness of the photoactive zone can be suppressed. Then, the inventors of the present application have found that, when arithmetic average roughness of the photoactive zone is suppressed, effects of the passivation layer are improved, which causes photoelectric conversion efficiency to be improved. That is, the inventors of the present application have found that, since the nanoparticle zone and the passivation layer produce a synergistic effect, the photoelectric conversion efficiency is improved.

In the photoelectric conversion device according to the present disclosure, the arithmetic average roughness of the photoactive zone may be 25 nm or less.

In the photoelectric conversion device according to the present disclosure, the arithmetic average roughness of the photoactive zone may be 20 nm or less.

In the photoelectric conversion device according to the present disclosure, nanoparticles may include zirconium oxide or silicon dioxide as a main component.

In the photoelectric conversion device according to the present disclosure, the passivation layer may include at least one of the compound represented by the following Formula (1) and salts thereof as a main component:

R¹(CH₂)ₙR² ··· (1)

where
R¹ is one of CH₃-, R³O-, R³S-, and -NH₂,
R² is one of R³O-, R³S-, and -NH₂,
R³ is an alkyl group, and
n is a natural number of 10 or less.

In the photoelectric conversion device according to the present disclosure, the passivation layer may include at least one of compounds represented by the following Formulas (2), (3), and (4) and salts thereof as a main component.

R³S(CH₂)ₙNH₂ ··· (2)

H₂N(CH₂)ₙNH₂ ··· (3)

CH₃(CH₂)ₙNH₂ ··· (4)

A method for manufacturing a photoelectric conversion device according to the present disclosure is a method for manufacturing a photoelectric conversion device including a first electrode layer, which is a transparent electrode, a second electrode layer, and a photoactive zone that is positioned between the first electrode layer and the second electrode layer. The method for manufacturing the photoelectric conversion device according to the present disclosure includes: a process of preparing a substrate including a first electrode layer; a process of forming a nanoparticle zone including nanoparticles; a process of forming a photoactive zone; and a process of forming a passivation layer.

In the method for manufacturing the photoelectric conversion device according to the present disclosure, the process of forming the passivation layer may include: a process of applying a precursor solution of the passivation layer on the photoactive zone; and a process of volatilizing a solvent of the precursor solution of the passivation layer.

In the method for manufacturing the photoelectric conversion device according to the present disclosure, nanoparticles may include zirconium oxide as a main component. Then, in the method for manufacturing the photoelectric conversion device according to the present disclosure, concentration of the precursor solution of the passivation layer may be 0.2 mM or more but 8.0 mM or less. Further, in the method for manufacturing the photoelectric conversion device according to the present disclosure, concentration of the precursor solution of the passivation layer may be 0.2 mM or more but 4.0 mM or less.

In the method for manufacturing the photoelectric conversion device according to the present disclosure, nanoparticles may include silicon dioxide as a main component. Then, in the method for manufacturing the photoelectric conversion device according to the present disclosure, concentration of the precursor solution of the passivation layer may be less than 2.0 mM.

A tandem solar cell according to the present disclosure includes a plurality of photoelectric conversion devices. One of the plurality of photoelectric conversion devices that is located on an outermost surface as viewed from a light-incident side includes: a first electrode layer, which is a transparent electrode; a second electrode layer; a photoactive zone that is positioned between the first electrode layer and the second electrode layer and contains a perovskite compound as a main component; a nanoparticle zone that is positioned between the photoactive zone and the first electrode layer and includes nanoparticles; and a passivation layer that is positioned between the photoactive zone and the second electrode layer.

A window glass according to the present disclosure includes a photoelectric conversion device. Then, the photoelectric conversion device includes: a first electrode layer, which is a transparent electrode; a second electrode layer; a photoactive zone that is positioned between the first electrode layer and the second electrode layer and contains a perovskite compound as a main component; a nanoparticle zone that is positioned between the photoactive zone and the first electrode layer and includes nanoparticles; and a passivation layer that is positioned between the photoactive zone and the second electrode layer.

According to the present disclosure, it is possible to provide a photoelectric conversion device, a method for manufacturing a photoelectric conversion device, a tandem solar cell, and a window glass capable of improving photoelectric conversion efficiency.

The above and other objects, features and advantages of the present disclosure will become more fully understood from the detailed description given hereinbelow and the accompanying drawings.

### BRIEF DESCRIPTION OF DRAWINGS

Fig. 1 is a cross-sectional view showing a configuration of a photoelectric conversion device according to a first embodiment;
Fig. 2 is a flowchart showing a method for manufacturing the photoelectric conversion device according to the first embodiment;
Fig. 3 is a cross-sectional view for describing the method for manufacturing the photoelectric conversion device according to the first embodiment;
Fig. 4 is a flowchart showing a configuration of the photoelectric conversion device according to the first embodiment;
Fig. 5 is a cross-sectional view for describing the method for manufacturing the photoelectric conversion device according to the first embodiment;
Fig. 6 is a cross-sectional view for describing the method for manufacturing the photoelectric conversion device according to the first embodiment;
Fig. 7 is a flowchart showing a configuration of the photoelectric conversion device according to the first embodiment; and
Fig. 8 is a cross-sectional view for describing the method for manufacturing the photoelectric conversion device according to the first embodiment.

### DESCRIPTION OF EMBODIMENTS

### <First Embodiment>

### (Configuration of Photoelectric Conversion Device)

Hereinafter, with reference to the drawings, a first embodiment according to the present disclosure will be described in detail. First, a configuration of a photoelectric conversion device according to this embodiment will be described in detail.

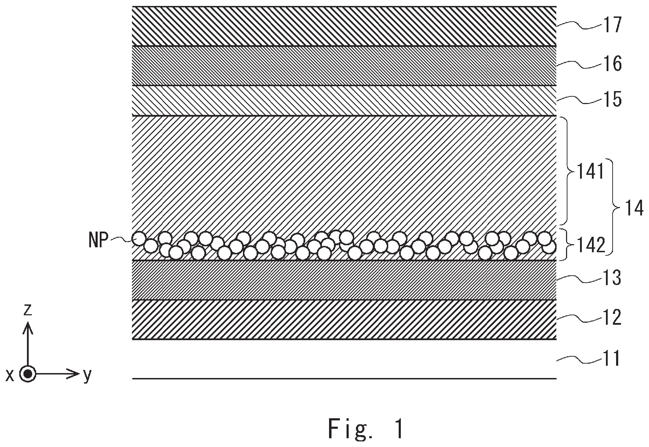

Fig. 1 is a cross-sectional view showing a configuration of the photoelectric conversion device according to the first embodiment. More specifically, Fig. 1 is a schematic cross-sectional view when the photoelectric conversion device according to the first embodiment is cut on a plane perpendicular to the main surface. As a matter of course, the right-handed xyz orthogonal coordinates shown in Fig. 1 and other drawings are for the sake of convenience in explaining the position relationship of the components, which are common throughout the drawings.

Further, the z-axis positive side may be herein expressed as an upper side and the z-axis negative side may be herein expressed as a lower side for the sake of convenience.

A photoelectric conversion device 1 according to this embodiment is a device that converts light incident from the z-axis positive side or the z-axis negative side into electric power. The photoelectric conversion device 1 is typically used as a solar cell. As shown in Fig. 1, the photoelectric conversion device 1 includes a substrate 11, a first electrode layer 12, a first carrier transport layer 13, a photoactive layer 14, a passivation layer 15, a second carrier transport layer 16, and a second electrode layer 17.

Note that the photoelectric conversion device 1 according to this embodiment may be used as an upper cell of a tandem solar cell.

While the details will be described later, the photoelectric conversion device 1 according to this embodiment can suppress reflection of incident light. Therefore, the photoelectric conversion device 1 according to this embodiment is used as one of a plurality of photoelectric conversion devices that is located on the outermost surface as viewed from the light-incident side in the tandem solar cell, whereby the amount of power generated in the photoelectric conversion device which is located in the deeper part as viewed from the light-incident side can be improved as well.

That is, the photoelectric conversion device 1 according to this embodiment provides special effects as it is used as the upper cell of the tandem solar cell.

Further, the photoelectric conversion device 1 according to this embodiment may be used, for example, for solar cells provided in a window glass of a vehicle or a building.

As described above, the photoelectric conversion device 1 according to this embodiment can suppress reflection of incident light. Therefore, the photoelectric conversion device 1 according to this embodiment allows more light to enter the interior of the vehicle or the building as it is used for the solar cells provided in the window glass of the vehicle or the building.

That is, the photoelectric conversion device 1 according to this embodiment provides special effects as it is applied to the solar cells provided in the window glass.

### (Configuration of Substrate 11)

The substrate 11, which is a plate-like or film-like member, is in contact with the first electrode layer 12 on the main surface on the z-axis positive side of the substrate 11.

The substrate 11 may be made of any material as long as the material transmits at least light having a wavelength band absorbed by the photoelectric conversion device 1. Specific examples of the material of the substrate 11 may include, for example, glass, resin, or the like.

From the viewpoint of manufacturing efficiency, the substrate 11 is preferably a film-like member made of a resin material. From the viewpoint of durability, the substrate 11 is preferably a plate-like member made of a glass material. The configuration of the substrate 11 can be selected as appropriate depending on the purpose and the like of using the photoelectric conversion device 1.

### (Configuration of First Electrode Layer 12)

The first electrode layer 12 is a layer having conductivity and light transmission properties. That is, the first electrode layer 12 is implemented as a transparent electrode layer.

The first electrode layer 12 is in contact with the substrate 11 on the main surface on the z-axis negative side of the first electrode layer 12, and is in contact with the first carrier transport layer 13 on the main surface on the z-axis positive side of the first electrode layer 12. That is, the first electrode layer 12 according to this embodiment is positioned between the substrate 11 and the first carrier transport layer 13.

The first electrode layer 12 receives carriers generated in the photoactive layer 14 via the first carrier transport layer and outputs the received carriers to the outside. The carriers here means holes or conduction electrons.

When the first carrier transport layer 13 that will be described later is a hole transport layer, the first electrode layer 12 receives the holes generated in the photoactive layer 14 as carriers and outputs the received holes to the outside.

Further, when the first carrier transport layer 13 is an electron transport layer, the first electrode layer 12 receives the conduction electrons generated in the photoactive layer 14 as carriers, and outputs the received conduction electrons to the outside.

The material of the first electrode layer 12 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

### (Configurations of First Carrier Transport Layer 13 and Second Carrier Transport Layer 16)

In the photoelectric conversion device 1 according to this embodiment, the first carrier transport layer 13 is a hole transport layer (HTL) and the second carrier transport layer 16 is an electron transport layer (ETL). That is, the photoelectric conversion device 1 according to this embodiment has an inverted structure.

However, the photoelectric conversion device according to the present disclosure may have a regular structure. That is, the photoelectric conversion device according to the present disclosure may include an electron transport layer (ETL) as the first carrier transport layer and a hole transport layer (HTL) as the second carrier transport layer.

### (Configuration of First Carrier Transport Layer 13)

As described above, the first carrier transport layer 13 according to this embodiment is a hole transport layer (HTL). The first carrier transport layer 13 is in contact with the first electrode layer 12 on the main surface on the z-axis negative side of the first carrier transport layer 13, and is in contact with the photoactive layer 14 on the main surface on the z-axis positive side of the first carrier transport layer 13. That is, the first carrier transport layer 13 according to this embodiment is positioned between the first electrode layer 12 and the photoactive layer 14.

The first carrier transport layer 13 transports holes generated in the photoactive layer 14 to the first electrode layer 12. In other words, the holes generated in the photoactive layer 14 move to the first electrode layer 12 via the first carrier transport layer 13.

As the material of the first carrier transport layer 13, both an inorganic hole transport material and an organic hole transport material can be used.

Examples of the inorganic hole transport material may include, for example, CuI, CuInSe₂, CuS, CuSCN, GaP, NiO, FeO, Bi₂O₃, MoO₃, and Cr₂O.

Examples of the organic hole transport material may include, for example, polythiophene derivatives, fluorene derivatives, carbazole derivatives, triphenylamine derivatives, diphenylamine derivatives, polysilane derivatives, and polyaniline derivatives.

Specific examples of the polythiophene derivatives include poly-3-hexylthiophene (P3HT) and polyethylene dioxythiophene (PEDOT). Specific examples of the fluorene derivatives include 2,2',7,7'-Tetrakis-(N,N-di-p-methoxyphenylamino)-9,9'-spirobifluorene (Spiro-OMeTAD). Specific examples of the carbazole derivatives include polyvinylcarbazole. Specific examples of the triphenylamine derivatives include poly[bis(4-phenyl)(2,4,6-trimethylphenyl)amine] (PTAA).

Note that the first carrier transport layer 13 according to this embodiment may be formed as a monomolecular film. In this case, the first carrier transport layer 13 may be a monomolecular film that is formed as a result of the compound expressed by the following Formula (5) bonding with the first electrode layer 12.

Ar-(L-Z)ₙ ··· (5)

where
Ar is an n-valent aryl group that may include a heteroaromatic ring,
L is a single bond or a divalent functional group,
Z is a monovalent functional group having bonding properties,
n is a natural number, and
when n is 2 or greater, each (L-Z) may be different from each other.

Ar is an n-valent aryl group that may include a heteroaromatic ring, and preferably includes a nitrogen atom in the heteroaromatic ring from the viewpoint of improving the hole transport properties. When Ar includes a heteroaromatic ring, Ar may have carbon atoms having a bonding hand, hetero atoms having a bonding hand, or both of them. Specific examples of Ar may include, for example, a carbazole ring and a triazatruxene ring.

L is a single bond or a divalent functional group. Note that, when L is a single bond, the compound represented by the chemical formula (5) has a structure where Ar and Z are directly bonded. Specific examples of L may include, for example, divalent alkylene groups such as a 1,1-methylene group or a 1,2-ethylene group, or divalent alkoxy groups such as a diethoxyethylene group.

Z is a monovalent functional group having bonding properties, and is a functional group capable of bonding to the transparent electrode layer and transferring charges to and from the transparent electrode layer. Specific examples of Z may include, for example, a phosphonic acid group, a carboxy group, a sulfo group, a boronic acid group, a trihalogenated silyl group, and a trialkoxysilyl group.

n is a natural number, and is preferably a natural number from 1 to 4. When n is 2 or greater, a plurality of (L-Z) may be the same or may be different from each other.

Specific examples of the compound represented by the above Formula (5) may include, for example, 3PATAT-C3 (Phosphonic acid functionalized triazatruxene).

### (Configuration of Photoactive Layer 14)

The photoactive layer 14 excites electrons by absorbing solar light that is incident from the z-axis negative side to generate holes and conduction electrons.

The holes generated in the photoactive layer 14 are transported to the first electrode layer 12 via the first carrier transport layer 13, and the conduction electrons generated in the photoactive layer 14 are transported to the second electrode layer 17 via the second carrier transport layer 16.

The photoactive layer 14 according to this embodiment may contain a perovskite compound as a main component, and may contain additives or the like as appropriate. Note that the perovskite compound here indicates a compound group having a perovskite-type crystal structure.

The compound that can be used as the main component of the photoactive layer 14 may include, for example, a perovskite compound expressed by a composition formula shown in the following Formula (6).

AMX₃··· (6)

where
A is a monovalent cation,
M is a divalent cation, and
X is a monovalent anion.

Specific examples of A may include, for example, alkylamine compound ions such as a methylammonium (MA) cation, an ethylammonium cation, and a formamidinium (FA) cation, or alkali-metal ions such as a potassium cation, a cesium cation, and a rubidium cation.

Note that the perovskite compound according to this embodiment may include a plurality of chemical species as A. From the viewpoint of photoelectric conversion efficiency and durability, the perovskite compound preferably includes a cesium cation, a methylammonium cation, and a formamidinium cation.

Specific examples of M may include, for example, a divalent metal ion such as lead, tin, antimony, indium, copper, bismuth, or germanium.

Note that the perovskite compound according to this embodiment may include a plurality of chemical species as M. From the viewpoint of photoelectric conversion efficiency and durability, the perovskite compound preferably includes at least one of a lead cation and a tin cation.

Specific examples of X may include, for example, halide ions such as fluorine, chlorine, bromine, and iodine.

Note that the perovskite compound according to this embodiment may include a plurality of chemical species as X. From the viewpoint of photoelectric conversion efficiency and durability, the perovskite compound preferably includes at least one of bromine and iodine.

The chemical species used as A, M, and X and its compositions can be adjusted as appropriate in accordance with the performance requested for the photoelectric conversion device. In other words, the photoelectric conversion device 1 according to this embodiment can adjust, for example, performance such as durability and absorption wavelength by adjusting the chemical species used as A, M, and X and its compositions.

As shown in Fig. 1, the photoactive layer 14 according to this embodiment includes a photoactive zone 141 and a nanoparticle zone 142. The photoactive zone 141 here indicates a region in the photoactive layer 14 according to this embodiment where the nanoparticles NP are not distributed, and the nanoparticle zone 142 indicates a region in the photoactive layer 14 according to this embodiment where the nanoparticles NP are distributed.

The photoactive zone 141 is a dense layer made of photoelectric conversion materials, and is, in this embodiment, a dense layer made of a perovskite compound. As described above, the photoactive zone 141 is a region where there are no nanoparticles NP. The photoactive zone 141 is in contact with the second carrier transport layer 16 on the main surface on the z-axis positive side via the passivation layer 15, and is in contact with the first carrier transport layer 13 on the main surface on the z-axis negative side via the nanoparticle zone 142. The photoactive zone 141 generates carriers by absorbing the incident light.

Note that the expression "there are no nanoparticles NP" herein do not necessarily mean that there are no nanoparticles NP in a strict sense. That is, the expression "there are no nanoparticles NP" also includes a case in which a small amount of nanoparticles NP are unexpectedly mixed into the photoactive zone 141 in a manufacturing process or the like.

From the viewpoint of improving carrier transport efficiency, the photoactive zone 141 and the first carrier transport layer 13 are preferably not strictly isolated from each other by the nanoparticles NP. In other words, it is preferable that there is a region where the photoactive zone 141 and the first carrier transport layer 13 contact each other without the nanoparticles NP interposed therebetween on the boundary between the photoactive layer 14 and the first carrier transport layer 13.

As shown in Fig. 1, in this embodiment, the nanoparticle zone 142 and the first carrier transport layer 13 are spatially and electrically connected via a dense part made of photoelectric conversion materials distributed so as to fill the gaps between nanoparticles NP. With this configuration, the photoelectric conversion device 1 according to this embodiment can improve the carrier transport efficiency.

The nanoparticle zone 142 is a layered region containing the nanoparticles NP that are at least one of an insulator and a semiconductor. In other words, the nanoparticle zone 142 is a region in the photoactive layer 14 where the nanoparticles NP are distributed.

As shown in Fig. 1, the nanoparticle zone 142 according to this embodiment is formed of nanoparticles NP that are distributed in a layer shape and a dense part formed of photoelectric conversion materials distributed so as to fill the gaps between nanoparticles NP.

As shown in Fig. 1, the nanoparticle zone 142 according to this embodiment is positioned between the photoactive zone 141 and the first carrier transport layer 13, and contains nanoparticles NP that are an insulator or a semiconductor.

In the nanoparticle zone 142, the light incident from the z-axis negative side is scattered by the distributed nanoparticles NP. As a result, the nanoparticle zone 142 according to this embodiment can suppress reflection of the incident light. After the nanoparticle zone 142 suppresses reflection of the incident light, the amount of light supplied to the photoactive zone 141 increases. As a result, the photoelectric conversion device 1 according to this embodiment can improve the photoelectric conversion efficiency.

Further, while the details will be described later, as a result of thorough study, the inventors of the present application have found that, since the photoactive layer 14 includes the nanoparticle zone 142, arithmetic average roughness of the main surface on the upper side of the photoactive zone 141 is reduced.

The nanoparticles NP, which are at least one of an insulator and a semiconductor, may be, for example, metal oxide.

When the nanoparticles NP are an insulator, the main component of the nanoparticles NP may include, for example, silicon dioxide and aluminum nitride.

When the nanoparticles NP are a semiconductor, the main component of the nanoparticles NP may include, for example, zirconium oxide, yttrium oxide, silicon carbide, and titania.

From the viewpoint of suppressing the arithmetic average roughness of the main surface of the photoactive layer 14, the nanoparticles NP preferably include silicon dioxide or zirconium oxide as a main component, and particularly preferably include zirconium oxide as a main component.

From the viewpoint of suppressing the reflection of the incident light, the average particle diameter of the nanoparticles NP is preferably greater than 11 nm, further preferably 15 nm or more, and particularly preferably 45 nm or more. Further, from the viewpoint of improving the photoelectric conversion efficiency, the average particle diameter of the nanoparticles NP is preferably 122 nm or less.

When the main component of the nanoparticles is an insulator, from the viewpoint of improving the photoelectric conversion efficiency, the thickness of the nanoparticle zone 142 is preferably 200 nm or less, further preferably 59 nm or more but 110 nm or less, and particularly preferably 61 nm or more but 87 nm or less.

Further, when the main component of the nanoparticles is a semiconductor, from the viewpoint of improving the photoelectric conversion efficiency, the thickness of the nanoparticle zone 142 is preferably 200 nm or less, further preferably 19 nm or more but 86 nm or less, and particularly preferably 30 nm or more but 86 nm or less.

From the viewpoint of improving the photoelectric conversion efficiency, the thickness of the nanoparticle zone 142 is preferably 0.26 times or less of the thickness of the photoactive layer 14, further preferably 0.05 times or more but 0.20 times or less of the thickness of the photoactive layer 14, and particularly preferably 0.08 times or more but 0.13 times or less of the thickness of the photoactive layer 14.

In other words, the thickness of the nanoparticle zone 142 is preferably 0.26 times or less, further preferably 0.05 times or more but 0.20 times or less, and particularly preferably 0.08 times or more but 0.13 times or less of a total thickness of the photoactive zone and the nanoparticle zone.

Further specifically, when the main component of the nanoparticles is an insulator, from the viewpoint of improving the photoelectric conversion efficiency, the thickness of the nanoparticle zone 142 is preferably 0.26 times or less of the thickness of the photoactive layer 14, further preferably 0.08 times or more but 0.16 times or less of the thickness of the photoactive layer 14, and particularly preferably 0.08 times or more but 0.12 times or less of the thickness of the photoactive layer 14.

In other words, when the main component of the nanoparticles is an insulator, from the viewpoint of improving the photoelectric conversion efficiency, the thickness of the nanoparticle zone 142 is preferably 0.26 times or less, further preferably 0.08 times or more but 0.16 times or less, and particularly preferably 0.08 times or more but 0.12 times or less of a total thickness of the photoactive zone 141 and the nanoparticle zone 142.

Further, when the main component of the nanoparticles is a semiconductor, from the viewpoint of improving the photoelectric conversion efficiency, the thickness of the nanoparticle zone 142 is preferably 0.24 times or less of the thickness of the photoactive layer 14, further preferably 0.05 times or more but 0.20 times or less of the thickness of the photoactive layer 14, and particularly preferably 0.08 times or more but 0.13 times or less of the thickness of the photoactive layer 14.

In other words, when the main component of the nanoparticles is a semiconductor, from the viewpoint of improving the photoelectric conversion efficiency, the thickness of the nanoparticle zone 142 is preferably 0.24 times or less, further preferably 0.05 times or more but 0.20 times or less, and particularly preferably 0.08 times or more but 0.13 times or less of a total thickness of the photoactive zone 141 and the nanoparticle zone 142.

Note that the thickness of the nanoparticle zone here may be defined to be a thickness from the upper end to the lower end of the nanoparticle zone in the vertical cross section of the photoelectric conversion device.

The thickness of the nanoparticle zone may be measured, for example, by observation using a scanning electron microscope (SEM). In this case, the thickness of the nanoparticle zone may be measured as a distance from the upper end of the layer positioned in the lower part of the nanoparticle zone to the topmost end of the nanoparticles in the part where nanoparticles are deposited the most in a cross-sectional SEM image. Further, the thickness of the nanoparticle zone may be calculated as an average value of a plurality of values measured from cross-sectional SEM images captured in a plurality of fields of view, that is, a plurality of cross-sectional SEM images captured from different cross sections.

Further, the thickness of the photoactive zone here may be defined to be a thickness from the upper end to the lower end of the nanoparticle zone in the vertical cross section of the photoelectric conversion device.

The thickness of the photoactive zone can be measured, for example, by observation using a scanning electron microscope (SEM). In this case, the thickness of the photoactive zone may be measured as a distance from the lower end of the layer positioned in the upper part of the photoactive zone to the topmost end of the nanoparticles of the part where the nanoparticles are deposited the most in a cross-sectional SEM image. Further, the thickness of the photoactive zone may be calculated as an average value of a plurality of values measured from cross-sectional SEM images captured in a plurality of fields of view, that is, a plurality of cross-sectional SEM images captured from different cross sections.

Further, the thickness of the photoactive layer herein may be defined to be a thickness from the upper end of the nanoparticle zone or the photoactive zone in the vertical cross section of the photoelectric conversion device to the lower end of the nanoparticle zone or the photoactive zone.

The thickness of the photoactive layer can be measured, for example, by observation using a scanning electron microscope (SEM). In this case, the thickness of the photoactive zone may be measured as a distance from the topmost end of the nanoparticle zone or the photoactive zone to the lowermost end of the nanoparticle zone or the photoactive zone in the cross-sectional SEM.

Further, the thickness of the photoactive layer may be calculated as an average value of a plurality of values measured from cross-sectional SEM images captured in a plurality of fields of view, that is, a plurality of cross-sectional SEM images captured from different cross sections.

Further, the thickness of the photoactive zone may be calculated as a sum of the respective measurement results of the thickness of the nanoparticle zone and the thickness of the photoactive zone.

### (Configuration of Passivation Layer 15)

The passivation layer 15 is a layer that is positioned on the z-axis positive side of the photoactive layer 14. The main component of the passivation layer 15 is bonded with the structural defects of perovskite crystals included in the photoactive layer 14, whereby recombination of carriers is suppressed.

The passivation layer 15 may include, for example, at least one of the compound represented by the following Formula (1) and salts thereof as a main component. Specific examples of salts include a salt of the compound expressed by the following Formula (1) and halogenated hydrogen such as hydrogen iodide.

R¹(CH₂)ₙR² ··· (1)

where
R¹ is one of CH₃-, R³O-, R³S-, and -NH₂,
R² is one of R³O-, R³S-, and -NH₂,
R³ is an alkyl group, and
n is a natural number of 10 or less.

Further, from the viewpoint of improving the photoelectric conversion efficiency, the passivation layer 15 preferably includes at least one of compounds represented by the following Formulas (2), (3), and (4) and salts thereof as a main component.

R³S(CH₂)ₙNH₂··· (2)

H₂N(CH₂)ₙNH₂··· (3)

CH₃(CH₂)ₙNH₂··· (4)

Here, the compounds represented by the above Formulas (1)-(4) include at least one or more of functional groups represented by R³O-, R³S-, and -NH₂. These functional groups are bonded with structural defects of perovskite crystals formed by a perovskite compound, as a result of which occurrence of a phenomenon that reduces, for example, photoelectric conversion efficiency, such as recombination of carriers, is suppressed.

That is, the main component of the passivation layer 15 is bonded with structural defects of perovskite crystals on the main surface of the photoactive zone 141, whereby the photoelectric conversion efficiency can be improved.

Note that examples of the compound that can be used as the main component of the passivation layer include, for example, compounds described in "Bimolecularly passivated interface enables efficient and stable inverted perovskite solar cells" (Cheng, Liu. et al., Science, 2023, 382, pages 810-815).

However, the compound that can be used as the main component of the passivation layer according to this embodiment is not limited to the compounds represented by the above Formulas (1)-(4).

The compound that can be used as the main component of the passivation layer may be any compound as long as it can suppress decrease in the photoelectric conversion efficiency as a result of being bonded with structural defects of the perovskite compound.

Further, the passivation layer 15 does not necessarily form a layer in a strict sense, and may be a so-called monolayer.

Further, in the present disclosure, the term "passivation layer" may be used for convenience to denote a region where compounds capable of bonding with structural defects of perovskite crystals are distributed on a boundary between the photoactive layer 14 and a second carrier transport layer that will be described layer. That is, the expression "include the passivation layer" herein may mean that at least a part of the boundary included in the photoactive layer 14 is subjected to surface treatment by compounds capable of bonding with the structural defects of the perovskite compounds.

Further, as described above, as a result of thorough study, the inventors of the present application have found that, when the photoactive layer 14 includes the nanoparticle zone 142, the arithmetic average roughness of the main surface on the upper side of the photoactive zone 141 is reduced. The inventors of the present application have also found that, when the arithmetic average roughness of the main surface on the upper side of the photoactive zone 141 has been reduced, the effect of the passivation layer 15 formed be in touch with the upper side of the photoactive zone 141 is improved, which causes the photoelectric conversion efficiency to be further improved.

### (Configuration of Second Carrier Transport Layer 16)

As described above, the second carrier transport layer 16 according to this embodiment is an electron transport layer (ETL). The second carrier transport layer 16 is in contact with the photoactive layer 14 through the passivation layer 15 on the main surface on the z-axis negative side of the second carrier transport layer 16, and is in contact with the second electrode layer 17 on the main surface on the z-axis positive side of the second carrier transport layer 16. That is, the second carrier transport layer 16 according to this embodiment is positioned between the photoactive layer 14 and the second electrode layer 17.

The second carrier transport layer 16 transports conduction electrons generated in the photoactive layer 14 to the second electrode layer 17. In other words, the conduction electrons generated in the photoactive layer 14 are transported to the second electrode layer 17 via the second carrier transport layer 16.

Examples of the compound that can be used as a main component of the second carrier transport layer 16 include single-electron transport materials, oxide electron transport materials, sulfide electron transport materials, and organic electron transport materials.

Specific examples of the single-electron transport materials may include, for example, silicon or germanium. Specific examples of the oxide electron transport materials may include, for example, oxides of titanium, tin, zinc, iron, tungsten, zirconium, hafnium, strontium, indium, cerium, yttrium, lanthanum, vanadium, niobium, and tantalum. Specific examples of the sulfide electron transport materials may include, for example, sulfides of cadmium, zinc, lead, silver, antimony, and bismuth. Specific examples of the organic electron transport materials may include, for example, fullerene derivatives such as fullerene C₆₀ or Phenyl-C₆₁-Butyric acid Methyl ester (PCBM, [6,6]-Phenyl-C₆₁-Butyric acid Methyl ester).

### (Configuration of Second Electrode Layer 17)

The second electrode layer 17 is a conductive layer. The second electrode layer 17 is in contact with the second carrier transport layer 16 on the main surface on the z-axis negative side of the second electrode layer 17.

The second electrode layer 17 receives carriers generated in the photoactive layer 14 via the second carrier transport layer 16, and outputs the received carriers to the outside.

When the aforementioned second carrier transport layer 16 is an electron transport layer, the second electrode layer 17 receives conduction electrons generated in the photoactive layer 14 as carriers and outputs the received conduction electrons to the outside.

Further, when the second carrier transport layer 16 is a hole transport layer, the second electrode layer 17 receives the holes generated in the photoactive layer 14 as carriers and outputs the received holes to the outside.

The second electrode layer 17 may be an electrode layer having light transmission properties, or may be an electrode layer that does not have light transmission properties. That is, the second electrode layer 17 may be a transparent electrode layer or may not be a transparent electrode layer. In other words, the photoelectric conversion device 1 according to this embodiment may be a transparent photoelectric conversion device or may be a non-transparent photoelectric conversion device.

As described above, the photoelectric conversion device 1 according to this embodiment achieves special effects when it is used as an upper cell of a tandem solar cell or when it is used as a photoelectric conversion device of a solar cell used as a window glass. In these cases, the photoelectric conversion device 1 is transparent. That is, in the above cases, the second electrode layer 17 is implemented as a transparent electrode layer.

When the second electrode layer 17 is a transparent electrode layer, the material of the second electrode layer 17 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

Note that the first electrode layer 12 and the second electrode layer 17 may be made of the same material or may be made of materials different from each other.

When the second electrode layer 17 is not a transparent electrode layer, examples of the material of the second electrode layer 17 may include, for example, metal such as gold, silver, copper, aluminum, tungsten, titanium, chromium, nickel, and cobalt.

As described above, the photoelectric conversion device 1 according to this embodiment includes a first electrode layer 12, which is a transparent electrode; a second electrode layer 17; a photoactive zone 141 that is positioned between the first electrode layer 12 and the second electrode layer 17 and contains a perovskite compound as a main component; a nanoparticle zone 142 that is positioned between the photoactive zone 141 and the first electrode layer 12 and includes nanoparticles; and a passivation layer 15 that is positioned between the photoactive zone 141 and the second electrode layer 17.

With the aforementioned configuration, the nanoparticle zone 142 and the passivation layer 15 produce a synergistic effect, and photoelectric conversion efficiency of the photoelectric conversion device 1 according to this embodiment can be improved.

### (Method for manufacturing Photoelectric Conversion Device)

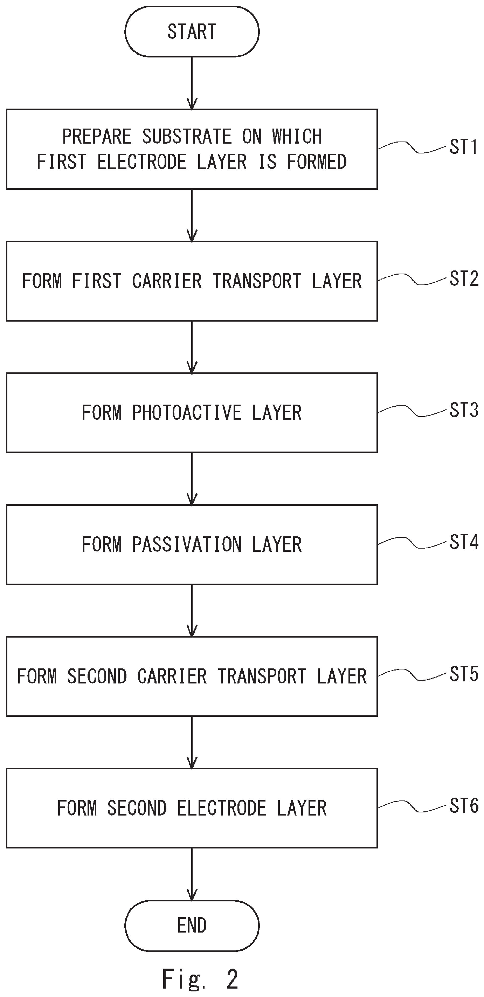

Next, a method for manufacturing a photoelectric conversion device according to this embodiment will be described in detail. Fig. 2 is a flowchart showing the method for manufacturing the photoelectric conversion device according to the first embodiment.

In the method for manufacturing the photoelectric conversion device according to this embodiment, first, a substrate 11 on which a first electrode layer 12 is formed is prepared (Step ST1).

Note that Step ST1 may be a process of forming the first electrode layer 12 on the substrate 11, or may be a process of preparing a commercially-available transparent electrode substrate.

In the method for manufacturing the photoelectric conversion device according to this embodiment, next, a first carrier transport layer 13 is formed (Step ST2). More specifically, in Step ST2, the first carrier transport layer 13 is formed on the first electrode layer 12.

The method for forming the first carrier transport layer 13 may include a method in which a solution in which the material of the first carrier transport layer 13 is dissolved is applied and then a solvent is volatilized, a method for vacuum-depositing the material of the first carrier transport layer 13, or the like. The method for forming the first carrier transport layer 13 can be selected as appropriate depending on the material of the first carrier transport layer 13.

Note that the method for applying the solution may include, for example, an inkjet method, a spray coating method, a die coating method, and a spin coating method.

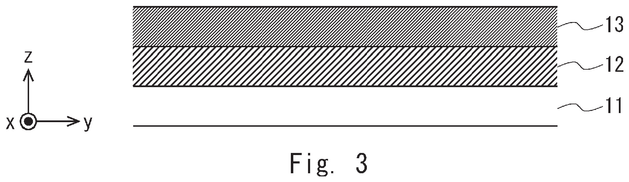

Fig. 3 is a schematic cross-sectional view for describing the method for manufacturing the photoelectric conversion device according to the first embodiment. More specifically, Fig. 3 is a schematic cross-sectional view showing a configuration of the photoelectric conversion device 1 after Step ST2 is completed but before Step ST3 is performed.

As shown in Fig. 3, in the photoelectric conversion device 1 after ST2 is completed, the first carrier transport layer 13 is formed on the first electrode layer 12.

In the method for manufacturing the photoelectric conversion device according to this embodiment, next, a photoactive layer 14 is formed (Step ST3). More specifically, in Step ST3, the photoactive layer 14 is formed on the first carrier transport layer 13. Note that, as described above, the photoactive layer 14 according to this embodiment includes the photoactive zone 141 and the nanoparticle zone 142.

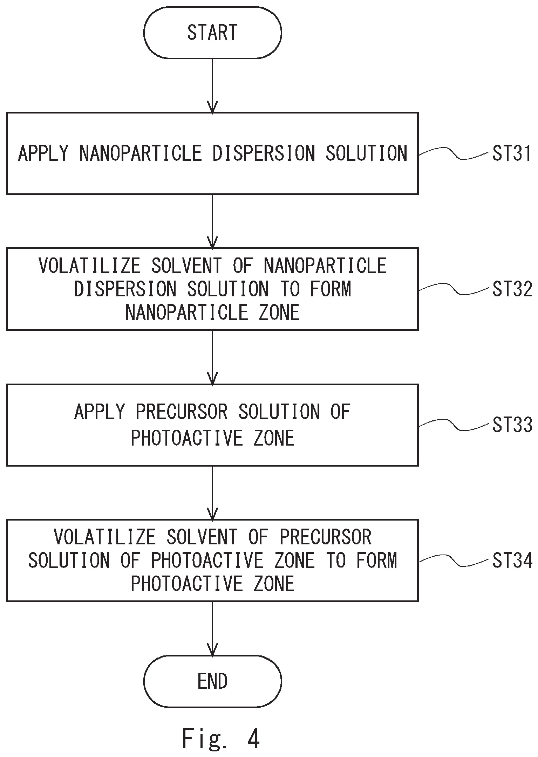

Fig. 4 is a flowchart showing a method for manufacturing the photoelectric conversion device according to the first embodiment. More specifically, Fig. 4 is a flowchart showing the process of Step ST3 in Fig. 2 in more detail.

In Step ST3, first, a nanoparticle dispersion solution is applied (Step ST31). More specifically, in Step ST31, a nanoparticle dispersion solution is applied onto the first carrier transport layer 13.

Note that the method for applying the solution may include, for example, an inkjet method, a spray coating method, a die coating method, and a spin coating method.

Note that the concentration of the nanoparticle dispersion solution to be applied can be set as appropriate depending on the type of the nanoparticles to be used. From the viewpoint of suppressing the reflection of the incident light, the concentration of the nanoparticle dispersion solution is preferably 4.0 wt% or less.

In Step ST3, next, the solvent of the nanoparticle dispersion solution is volatilized. (Step ST32).

As a result of execution of Step ST32, the nanoparticles dispersed in the solution are deposited on the first carrier transport layer 13. While the details will be described later, a dense part of the photoelectric conversion material is formed in gaps between the deposited nanoparticles, whereby the nanoparticle zone 142 is formed.

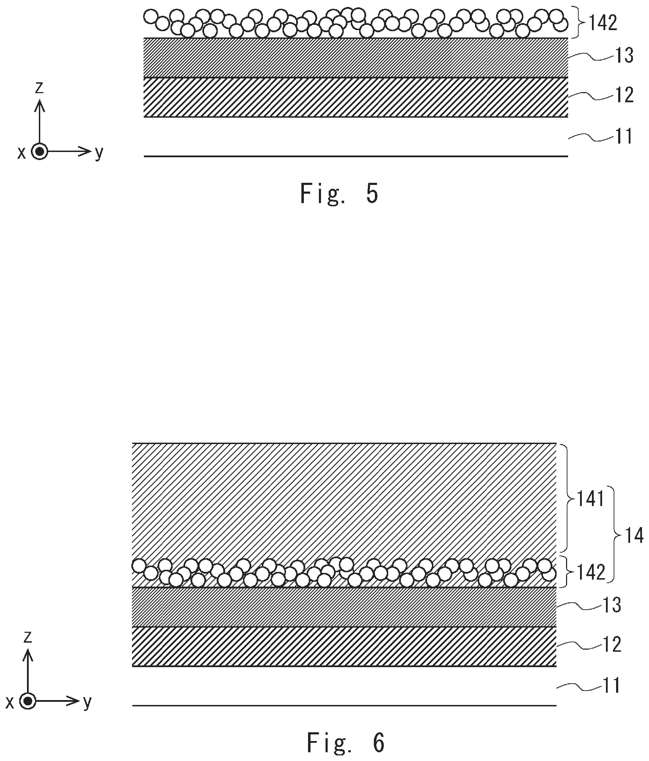

Fig. 5 is a schematic cross-sectional view for describing the method for manufacturing the photoelectric conversion device according to the first embodiment. More specifically, Fig. 5 is a schematic cross-sectional view showing a configuration of the photoelectric conversion device 1 after Step ST32 is completed but before Step ST33 is performed.

As shown in Fig. 5, in the photoelectric conversion device 1 after Step ST32 is completed, the nanoparticles NP are deposited on the first carrier transport layer 13.

It can be said, in the photoelectric conversion device 1 after Step ST32 is completed, that the nanoparticles are uniformly distributed on the first carrier transport layer 13, or a nanoparticle layer is formed thereon.

In Step ST3, next, a precursor solution of the photoactive zone 141 is applied (Step ST33). More specifically, in Step ST33, the precursor solution of the photoactive zone 141 is applied onto the first carrier transport layer 13 having a surface on which the nanoparticles NP are deposited. Note that the precursor solution of the photoactive zone 141 here is a solution including a photoelectric conversion material as a solute. In this embodiment, the precursor solution of the photoactive zone 141 is a solution including a perovskite compound as a solute.

As a result of execution of Step ST33, the precursor solution of the photoactive zone 141 permeates into gaps between the deposited nanoparticles NP. Further, as a result of execution of Step ST33, a liquid film of the precursor solution is formed in the upper part of the deposited nanoparticles NP.

The method for applying the solution may include, for example, an inkjet method, a spray coating method, a die coating method, and a spin coating method.

In Step ST3, lastly, a solvent of the precursor solution of the photoactive zone 141 is volatilized. (Step ST34). As a result of execution of Step ST34, the formation of the photoactive layer 14 is completed. As a result of execution of Step ST34, the photoelectric conversion material precipitates so as to fill the gaps between the deposited nanoparticles NP, whereby the nanoparticle zone 142 is formed. Further, as a result of execution of Step ST34, the photoelectric conversion material precipitates in the upper part of the nanoparticle zone 142, whereby the photoactive zone 141 is formed.

Fig. 6 is a schematic cross-sectional view for describing the method for manufacturing the photoelectric conversion device according to the first embodiment. More specifically, Fig. 6 is a schematic cross-sectional view showing a configuration of the photoelectric conversion device 1 after Step ST34 is completed but before Step ST4 is performed.

As shown in Fig. 6, in the photoelectric conversion device 1 after Step ST34 is completed, the photoactive zone 141 is formed on the nanoparticle zone 142.

Referring back to Fig. 2, the explanation will be continued.

In the method for manufacturing the photoelectric conversion device according to this embodiment, next, the passivation layer 15 is formed (Step ST4). More specifically, in Step ST4, the passivation layer 15 is formed on the photoactive layer 14. It can also be said that Step ST4 is a process of "performing surface treatment on the main surface on the upper side of the photoactive layer 14".

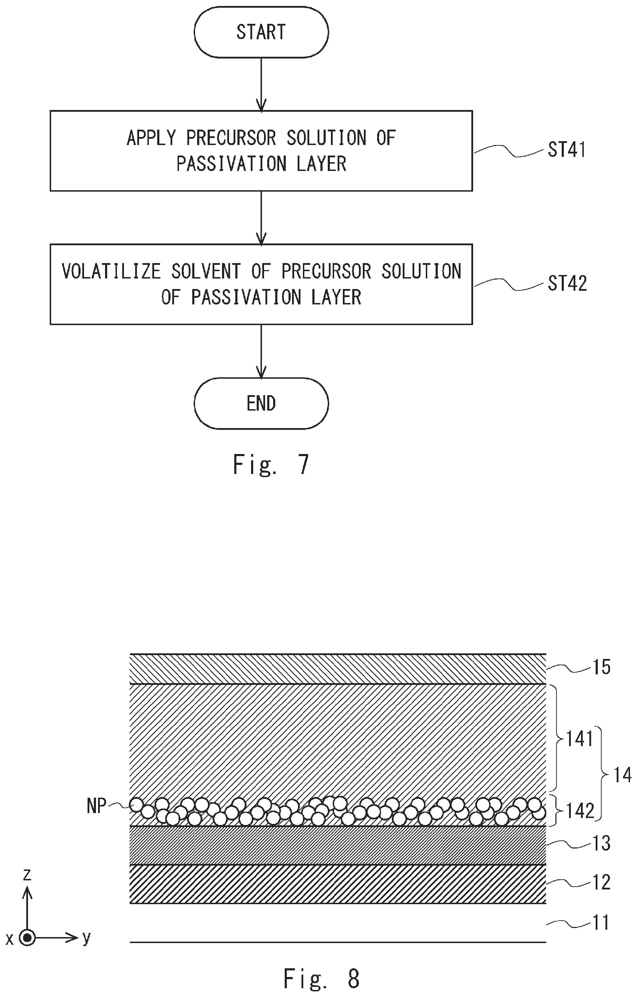

Fig. 7 is a flowchart showing the method for manufacturing the photoelectric conversion device according to the first embodiment. More specifically, Fig. 7 is a flowchart showing the process of Step ST4 in Fig. 2 in more detail.

In Step ST4, first, a precursor solution of the passivation layer 15 is applied (Step ST41). More specifically, in Step ST41, the precursor solution of the passivation layer is applied onto the photoactive layer 14.

Note that the method for applying the precursor solution may include, for example, an inkjet method, a spray coating method, a die coating method, and a spin coating method.

Here, the precursor solution of the passivation layer 15 is, for example, a solvent in which the compounds represented by the above Formulas (1)-(4) are dissolved into a solvent such as isopropanol and chlorobenzene.

From the viewpoint of improving the photoelectric conversion efficiency, when the nanoparticles NP are a semiconductor, the concentration of the precursor solution of the passivation layer is preferably 0.2 mM or more but 8.0 mM or less, more preferably 0.2 mM or more but 0.6 mM or less, and particularly preferably 0.2 mM or more but 0.4 mM or less. Further, from the viewpoint of improving the photoelectric conversion efficiency, when the nanoparticles NP are an insulator, the concentration of the precursor solution of the passivation layer is preferably 0.2 mM or more but less than 2.0 mM.

In Step ST4, lastly, the solvent of the precursor solution of the passivation layer 15 is volatilized (Step ST42). As a result of execution of Step ST34, the formation of the passivation layer 15 is completed.

Fig. 8 is a schematic cross-sectional view for describing the method for manufacturing the photoelectric conversion device according to the first embodiment. More specifically, Fig. 8 is a schematic cross-sectional view showing a configuration of the photoelectric conversion device 1 after Step ST4 is completed but before Step ST5 is performed.

As shown in Fig. 8, in the photoelectric conversion device 1 after Step ST4 is completed, the passivation layer 15 is formed on the photoactive layer 14.

Referring back to Fig. 2, the explanation will be continued.

In the method for manufacturing the photoelectric conversion device according to this embodiment, next, the second carrier transport layer 16 is formed (Step ST5). More specifically, in Step ST5, the second carrier transport layer 16 is formed on the passivation layer 15.

The method for forming the second carrier transport layer 16 may include a method in which a solution in which the material of the second carrier transport layer 16 is dissolved is applied and then a solvent is volatilized, a method for vacuum-depositing the material of the second carrier transport layer 16, or the like. The method for forming the second carrier transport layer 16 can be selected as appropriate depending on the material of the second carrier transport layer 16.

Note that the method for applying the solution may include, for example, an inkjet method, a spray coating method, a die coating method, and a spin coating method.

In the method for manufacturing the photoelectric conversion device according to this embodiment, lastly, the second electrode layer 17 is formed (Step ST5), whereby the photoelectric conversion device 1 is completed.

More specifically, in Step ST5, the second electrode layer 17 is formed on the second carrier transport layer 16. As a result of execution of Step ST5, the state of the photoelectric conversion device according to this embodiment is as shown in Fig. 1.

The method for forming the second electrode layer 17 may include a method in which a solution in which the material of the second electrode layer 17 is dissolved is applied and then a solvent is volatilized, a method for vacuum-depositing the material of the second electrode layer 17, or the like. The method for forming the second electrode layer 17 can be selected as appropriate depending on the material of the second electrode layer 17.

Note that the method for applying the solution may include, for example, an inkjet method, a spray coating method, a die coating method, and a spin coating method.

As described above, the method for manufacturing the photoelectric conversion device according to this embodiment includes a process of preparing a substrate including a first electrode layer, a process of forming a nanoparticle zone including nanoparticles, a process of forming a photoactive zone, and a process of forming a passivation layer. According to this manufacturing method, the photoelectric conversion device according to the present disclosure can be manufactured.

### [Examples]

Hereinafter, the present disclosure will be described in further detail with reference to Examples. The present disclosure is not limited to the following Examples. In the following description, "%" is "mass %" unless otherwise specified.

### <Preparation of Photoelectric Conversion Device>

### (Example 1)

3PATAT-C3 was dissolved in N,N-dimethylformamide (DMF) to prepare a solution. The prepared precursor solution of the hole transport layer was applied onto an ITO glass substrate by spin coating. After that, the applied precursor solution of the hole transport layer was annealed to form a hole transport layer. Note that these processes correspond to Steps ST1 and ST2 in Fig. 2.

Next, nanoparticles of zirconium oxide whose average particle diameter is 13.4 nm was dispersed into isopropyl alcohol at a concentration of 2 wt% to prepare a nanoparticle dispersion solution. The prepared nanoparticle dispersion solution was applied onto the formed hole transport layer by spin coating. After that, the applied nanoparticle dispersion solution was annealed at 110 degrees Celsius. Note that these processes correspond to Steps ST31 and ST32 in Fig. 5.

Note that the average particle dimeter of the nanoparticles is a value measured by observation using a scanning electron microscope (SEM). 12 particles were randomly extracted from an image captured by the scanning electron microscope and the diameters of the nanoparticles were measured and then an average value and the standard deviation thereof were calculated. As described above, the average value was 13.4 nm and the standard deviation was 2.16. The maximum value of the diameters of the nanoparticles that have been measured was 10.0 nm and the minimum value thereof was 17.2 nm.

Next, cesium iodide (CsI), methylammonium bromide (MABr), formamidinium iodide (FAI), lead iodide (PbI₂), and lead bromide (PbBr₂) were dissolved into a mixed solvent of N,N-dimethylformamide (DMF) and dimethyl sulfoxide (DMSO), and a precursor solution of the photoactive zone was prepared. The prepared precursor solution of the photoactive zone was applied onto the deposited nanoparticles by spin coating, and chlorobenzene was dropped to the applied precursor solution of the photoactive zone. After that, annealing was performed to form a photoactive zone and a nanoparticle zone. These processes correspond to Step ST3 in Fig. 5.

Next, Ethylenediamine Dihydroiodide (EDAI₂) was dissolved into a mixed solvent of isopropanol and chlorobenzene in such a way that the concentration becomes 0.2 mM to prepare a precursor solution of the passivation layer. The prepared precursor solution of the passivation layer was applied, by spin coating, onto the substrate in which the perovskite layer was formed, and then the solvent was dried to form a passivation layer. These processes correspond to Step ST4 in Fig. 2.

Next, [6,6]-phenyl-C₆₁-butyric acid methyl ester was dissolved into 2-propanol, and a solution was prepared. The prepared solution was applied, by spin coating, onto a substrate on which a passivation layer was formed, and then the solvent was dried to form an electron transport layer. Note that these processes correspond to Step ST5 in Fig. 2.

Last, silver was vacuum-deposited onto the formed electron transport layer and a second electrode layer was formed, whereby the photoelectric conversion device according to Example 1 were prepared. This process corresponds to Step ST6 in Fig. 2.

### (Example 2)

A photoelectric conversion device was manufactured in a way similar to that in Example 1 except that the precursor solution of the passivation layer was adjusted in such a way that the concentration of Ethylenediamine Dihydroiodide (EDAI₂) becomes 2.0 mM.

### (Example 3)

A photoelectric conversion device was manufactured in a way similar to that in Example 1 except that the precursor solution of the passivation layer was adjusted in such a way that the concentration of Ethylenediamine Dihydroiodide (EDAI₂) becomes 4.0 mM.

### (Example 4)

A photoelectric conversion device was manufactured in a way similar to that in Example 1 except that the precursor solution of the passivation layer was adjusted in such a way that the concentration of Ethylenediamine Dihydroiodide (EDAI₂) becomes 6.0 mM.

### (Example 5)

A photoelectric conversion device was manufactured in a way similar to that in Example 1 except that the precursor solution of the passivation layer was adjusted in such a way that the concentration of Ethylenediamine Dihydroiodide (EDAI₂) becomes 8.0 mM.

### (Example 6)

A photoelectric conversion device was manufactured in a way similar to that in Example 1 except that the precursor solution of the passivation layer was adjusted in such a way that the concentration of Ethylenediamine Dihydroiodide (EDAI₂) becomes 10.0 mM.

### (Example 7)

A photoelectric conversion device was manufactured in a way similar to that in Example 1 except that nanoparticles of silicon dioxide whose average particle diameter is 65.8 nm was used in place of nanoparticles of zirconium oxide whose average particle diameter is 13.4 nm.

Note that the average particle diameter of the nanoparticles of silicon dioxide is a value measured by observation using a scanning electron microscope (SEM). 12 particles were randomly extracted from an image captured by the scanning electron microscope and the diameters of the nanoparticles were measured and then an average value and the standard deviation thereof were calculated. As described above, the average value was 65.8 nm and the standard deviation was 3.87. Further, the maximum value of the diameters of the nanoparticles that have been measured was 117.3 nm and the minimum value thereof was 43.8 nm.

### (Example 8)

A photoelectric conversion device was manufactured in a way similar to that in Example 7 except that the precursor solution of the passivation layer was adjusted in such a way that the concentration of Ethylenediamine Dihydroiodide (EDAI₂) becomes 2.0 mM.

### (Comparative Example 1)

A photoelectric conversion device was manufactured in a way similar to that in Example 1 except that the nanoparticle zone was not formed.

### (Comparative Example 2)

A photoelectric conversion device was manufactured in a way similar to that in Comparative Example 1 except that the precursor solution of the passivation layer was adjusted in such a way that the concentration of Ethylenediamine Dihydroiodide (EDAI₂) becomes 2.0 mM.

### (Comparative Example 3)

A photoelectric conversion device was manufactured in a way similar to that in Comparative Example 1 except that the precursor solution of the passivation layer was adjusted in such a way that the concentration of Ethylenediamine Dihydroiodide (EDAI₂) becomes 4.0 mM.

### (Comparative Example 4)

A photoelectric conversion device was manufactured in a way similar to that in Comparative Example 1 except that the precursor solution of the passivation layer was adjusted in such a way that the concentration of Ethylenediamine Dihydroiodide (EDAI₂) becomes 6.0 mM.

### <Measurement of Arithmetic Average Roughness of Photoactive Layer>

The arithmetic average roughness of the surface of the photoelectric conversion device in a state in which the formation of the photoactive layer is completed but formation of the passivation layer has not been started was measured by using a laser microscope.

As a result, in Comparative Example 2 in which the nanoparticle zone 142 is not provided, the arithmetic average roughness of the surface of the photoactive layer was 29.8 nm.

Further, in Example 7 which includes a nanoparticle zone including nanoparticles of zirconium dioxide, the arithmetic average roughness of the surface of the photoactive layer was 24.4 nm.

Further, in Example 1 which includes a nanoparticle zone including nanoparticles of zirconium oxide, the arithmetic average roughness of the surface of the photoactive layer was 19.0 nm.

### <Battery Performance Evaluation of Photoelectric Conversion Device>

For each of some of Examples, the prepared photoelectric conversion device was irradiated with light by using an air mass (AM) 1.5 G solar simulator, and photoelectric conversion efficiency, a short-circuit current, an open-circuit voltage, and a fill factor were measured. Table 1 shows the results.

**[Table 1]**

| Type of Nanoparticles | .Example | Passivation Layer Precursor Solution Concentration | Photoelectric Conversion Efficiency (Rate relative to Comparative Example 1) | Short-circuit Current (Rate relative to Comparative Example 1) | Open-circuit Voltage (Rate relative to Comparative Example 1) | Fill Factor (Rate relative to Comparative Example 1) |
|---|---|---|---|---|---|---|
| ZrO2 | Example 1 | 0.2 mM | 1.049 | 1.015 | 1.028 | 1.005 |
| | Example 2 | 2.0 mM | 1.078 | 1.038 | 1.044 | 0.996 |
| | Example 3 | 4.0 mM | 1.052 | 1.033 | 1.031 | 0.988 |
| | Example 4 | 6.0 mM | 1.037 | 1.028 | 1.032 | 0.977 |
| | Example 5 | 8.0 mM | 1.017 | 1.035 | 1.036 | 0.949 |
| | Example 6 | 10.0 mM | 0.972 | 1.019 | 1.034 | 0.922 |
| SiO2 | Example 7 | 0.2 mM | 1.040 | 1.033 | 1.056 | 0.953 |
| | Example 8 | 2.0 mM | 0.935 | 1.009 | 1.019 | 0.910 |
| No | Comparative Example 2 | 2.0 mM | 0.991 | 1.039 | 0.982 | 0.969 |
| | Comparative Example 3 | 4.0 mM | 0.900 | 1.037 | 0.974 | 0.889 |
| | Comparative Example 4 | 6.0 mM | 0.907 | 1.029 | 0.979 | 0.898 |

It has become clear, from Comparative Examples 2, 3, and 4, that, when the photoelectric conversion device does not include a nanoparticle zone, as the concentration of the precursor solution of the passivation layer increases from 0.2 mM, the photoelectric conversion efficiency is reduced.

On the other hand, it has become clear, from Examples 1 and 2, that, when the photoelectric conversion device includes a nanoparticle zone, as the concentration of the precursor solution of the passivation layer increases from 0.2 mM to 2.0 mM, the photoelectric conversion efficiency increases.

That is, it has become clear that there is a synergistic effect between the nanoparticle zone according to the Examples and the passivation layer that improves the photoelectric conversion efficiency of the photoelectric conversion device.

It has become clear, from the results in Examples 1, 2, 3, 4, 5, and 6, that the concentration of the precursor solution of the passivation layer is preferably 0.2 mM or more but 8.0 mM or less, more preferably 0.2 mM or more but 0.6 mM or less, and particularly preferably 0.2 mM or more but 0.4 mM or less.

Further, it has become clear, from the results in Examples 7 and 8, that, even when nanoparticles of silicon dioxide is used, when the concentration of the precursor solution of the passivation layer is less than 2.0 mM, it exhibits performance equivalent to that in Example 1.

Further, it has become clear, from the results of measuring the arithmetic average roughness of the photoactive layer and the results shown in Table 1, that the arithmetic average roughness of the photoactive layer is preferably 25 nm or less, and particularly preferably 20 nm or less.

While the present disclosure has been described in view of the aforementioned embodiment, the present disclosure is not limited to the configurations of the above embodiment. As a matter of course, the present disclosure includes various variations, modifications, and combinations that may be made by one skilled in the art within the scope of the disclosure set forth in the claims of the present application.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A photoelectric conversion device comprising:
a first electrode layer (12), which is a transparent electrode;
a second electrode layer (17);
a photoactive zone (141) that is positioned between the first electrode layer (12) and the second electrode layer (17) and contains a perovskite compound as a main component;
a nanoparticle zone (142) that is positioned between the photoactive zone (141) and the first electrode layer (12) and includes nanoparticles (NP); and
a passivation layer (15) that is positioned between the photoactive zone (141) and the second electrode layer (17).

2. The photoelectric conversion device according to claim 1, wherein arithmetic average roughness of the photoactive zone (141) is 25 nm or less.

3. The photoelectric conversion device according to claim 2, wherein arithmetic average roughness of the photoactive zone (141) is 20 nm or less.

4. The photoelectric conversion device according to any one of claims 1 to 3, wherein the nanoparticles (NP) include zirconium oxide or silicon dioxide as a main component.

5. The photoelectric conversion device according to claim 1, wherein the passivation layer (15) includes at least one of the compound represented by the following Formula (1) and salts thereof as a main component:
R¹(CH₂)ₙR² ··· (1)
where
R¹ is one of CH₃-, R³O-, R³S-, and -NH₂,
R² is one of R³O-, R³S-, and -NH₂,
R³ is an alkyl group, and
n is a natural number of 10 or less.

6. The photoelectric conversion device according to claim 5, wherein the passivation layer (15) includes at least one of compounds represented by the following Formulas (2), (3), and (4) and salts thereof as a main component.
R³S(CH₂)ₙNH₂ ··· (2)
H₂N(CH₂)ₙNH₂ ··· (3)
CH₃(CH₂)ₙNH₂ ··· (4)

7. A method for manufacturing a photoelectric conversion device comprising a first electrode layer (12), which is a transparent electrode, a second electrode layer (17), and a photoactive zone (141) that is positioned between the first electrode layer (12) and the second electrode layer (17), the method comprising:
a process of preparing a substrate (11) including the first electrode layer (12);
a process of forming a nanoparticle zone (142) including nanoparticles (NP);
a process of forming the photoactive zone (141); and
a process of forming a passivation layer (15).

8. The method for manufacturing the photoelectric conversion device according to claim 7, wherein
the process of forming the passivation layer (15) comprises:
a process of applying a precursor solution of the passivation layer (15) on the photoactive zone (141); and
a process of volatilizing a solvent of the precursor solution of the passivation layer (15).

9. The method for manufacturing the photoelectric conversion device according to claim 8, wherein
the nanoparticles (NP) include zirconium oxide as a main component, and
concentration of the precursor solution of the passivation layer (15) is 0.2 mM or more but 8.0 mM or less.

10. The method for manufacturing the photoelectric conversion device according to claim 9, wherein concentration of the precursor solution of the passivation layer (15) is 0.2 mM or more but 4.0 mM or less.

11. The method for manufacturing the photoelectric conversion device according to claim 8, wherein
the nanoparticles (NP) include silicon dioxide as a main component, and
concentration of the precursor solution of the passivation layer (15) is less than 2.0 mM.

12. A tandem solar cell comprising a plurality of photoelectric conversion devices (1), wherein
one of the plurality of photoelectric conversion devices (1) that is located on an outermost surface as viewed from a light-incident side comprises:
a first electrode layer (12), which is a transparent electrode;
a second electrode layer (17);
a photoactive zone (141) that is positioned between the first electrode layer (12) and the second electrode layer (17) and contains a perovskite compound as a main component;
a nanoparticle zone (142) that is positioned between the photoactive zone (141) and the first electrode layer (12) and includes nanoparticles (NP); and
a passivation layer (15) that is positioned between the photoactive zone (141) and the second electrode layer (17).

13. A window glass comprising a photoelectric conversion device (1), wherein
the photoelectric conversion device (1) comprises:
a first electrode layer (12), which is a transparent electrode;
a second electrode layer (17);
a photoactive zone (141) that is positioned between the first electrode layer (12) and the second electrode layer (17) and contains a perovskite compound as a main component;
a nanoparticle zone (142) that is positioned between the photoactive zone (141) and the first electrode layer (12) and includes nanoparticles (NP); and
a passivation layer (15) that is positioned between the photoactive zone (141) and the second electrode layer (17).
